(19) Europäisches Patentamt
European Patent Office
Office européen des brevets

(11) **EP 1 671 925 A1**

(12) **EUROPEAN PATENT APPLICATION**

(43) Date of publication:
**21.06.2006 Bulletin 2006/25**

(51) Int Cl.:
*B81C 1/00* (2006.01)          *G03F 7/00* (2006.01)
*B29C 59/02* (2006.01)

(21) Application number: **04028817.7**

(22) Date of filing: **06.12.2004**

(84) Designated Contracting States:
**AT BE BG CH CY CZ DE DK EE ES FI FR GB GR
HU IE IS IT LI LT LU MC NL PL PT RO SE SI SK TR**
Designated Extension States:
**AL BA HR LV MK YU**

(71) Applicant: **Liu, Wai Yip
Dundee DD3 6ND (GB)**

(72) Inventor: **Liu, Wai Yip
Dundee DD3 6ND (GB)**

(54) **Micromachining process for forming microstructures having arbitrarily sloped and/or profiled sidewalls or substructures**

(57)    The object of the present invention is to provide a three-dimensional microfabrication apparatus and method for photolithographic mass-fabrication of three-dimensional microstructures having arbitrarily sloped and/or profiled sidewalls or substructures. The process comprises: locating photo-curable material in a suitable reservoir; dehydrating the photo-curable material; annealing areas forming the upper boundaries of sloped or profiled sidewalls or substructures; providing one or more metal layers masking the areas of the photo-curable material where said material in the micro structure is not required; photolithographically patterning areas to be deformed using polymeric masks; mechanically disrupting the flatness of areas between or enclosed by the annealed areas to form the required sub-structures whilst the photocurable material is cooling; and selectively photopolymerising the regions required for forming the end microstructures.

## FIGURE 8a

**Description**

This invention relates to a micromachining process and apparatus, and particularly but not necessarily exclusively to a micromachining process and apparatus which allows the formation of microstructures having arbitrarily sloped side walls, substructures or regions to be formed.

Although the following description refers almost exclusively to the formation of three-dimensional microstructures in the form of valleys, islands, recesses or grooves, it will be appreciated by persons skilled in the art that the present invention can be used to form any required three-dimensional structure.

There are a number of micro-electromechanical techniques which are currently available for achieving three-dimensional microstructures with arbitrarily sloped side walls.

One such technique invented by the applicant (disclosed in Electron Devices for Microwave and Optoelectronic Applications, 2002. EDMO 2002. The 10th IEEE International Symposium on , 18-19 Nov. 2002, Page(s): 143 -148, titled "Polymer Micro-Heat-Pipe for InP/InGaAs Technologies") for use in the production of micro-conical structures employs a dehydrated, thick and viscous bath of photosensitive resin which is deposited onto a substrate over an integrated circuit (IC). Using a planar photomask, a guard ring is annealed onto the surface of the dehydrated resin by exposure to UV light. The guard ring is semi-solid and defines the upper edges of the conical recess containing micro structure which is to be formed. A metal ball is manually positioned on the resin above the integrated circuit and within the aperture of the guard ring. On cooling of the resin and following application of mechanical pressure on the ball, a conical recess is formed. The resin is then selectively exposed under a suitable UV radiation source to produce the conical structure. Whilst this process can readily be used for the production of conical recesses, it cannot be used for the mass production of microstructures having arbitrarily sloped side walls or arbitrary sloped side walls on which windows, holes or any required geometric features are fabricated.

Other micromachining techniques are known which produce arbitrary sloped or profiled three-dimensional structures, such as polymer moulding using microstereolithography, directing ions in deep-reactive-ion-etching using buried dielectric layers, localised electrochemical fabrication, micro-photoforming, spatial forming, high energy beam writing, inclined rotating ultra-violet lithography, grey-scale lithography, electroplating and/or the like. With the exception of mask based micromachining technologies, such as grey-scale lithography, the abovementioned techniques are generally time consuming and can only be used for small scale production (i.e., do not favour batch mode processing). In addition, these techniques require specialised and expensive equipment for the processes to be carried out, thereby limiting use of the same.

It is therefore an object of the present invention to provide an improved micromachining process and apparatus which removes the requirement for specialised equipment to be used, whilst allowing a range of three-dimensional micro structures to be inexpensively and rapidly produced for mass production, said microstructures having one or more non-arbitrarily sloped side side walls, substructures or regions.

It is a further object of the present invention to use a micromachining process to develop arbitrarily sloped or profiled substructures, regions or side walls by mechanical-surface-disruption, to fabricate required geometric features onto the said substructures using polymeric mask lithography, and to connect the said sloped substructures, regions or side walls to form one or more complete microstructures using conventional photolithography.

According to the present invention there is provided a method for fabricating one or more three-dimensional microstructures having arbitrarily sloped and/or profiled side walls or substructures, including the steps of :

a) locating photo-curable material in a suitable reservoir;
b) dehydrating the photo-curable material by heating;
c) providing one or more metal layers on one or more areas of the photo-curable material where said material in the microstructure is not required;
d) forming one or more annealed or partially annealed areas adjacent at least an upper surface of the photo-curable material for formation of upper boundaries of microstructures being fabricated;
e) forming one or more polymeric mask regions on the material for defining one or more geometric features onto one or more sloped surfaces of the microstructure;
f) heating the photocurable material from solid to semi-solid;
g) mechanically disrupting the areas between or enclosed by the annealed areas by applying pressure to form a microstructure having the arbitrarily sloped and/or profiled sidewalls whilst the photocurable material is cooling; and
h) photopolymerising the regions of the photo-curable material required for forming the microstructure.

Preferably any or any combination of the surface area of the annealed or partially annealed areas, the temperature of the photo-curable material at which mechanical surface disruption takes place and/or the speed at which the photo-curable material is disrupted can be changed to change the side wall profile of the microstructure formed.

Mechanical surface disruption is a step during which a pressure is mechanically applied to disrupt the surface flatness of a non-polymerized photocurable material while the said material is in viscoelastic or partially viscoelastic state. The deformed surfaces resulting from mechanical surface disruption can be selectively photo-polymerized to form sloped regions, substructures or side walls of a microstructure. The photocurable material forming a microstructure is preferably UV-transparent, solidifies at room temperature, and exhibits thermoplastic and viscoelastic behaviours at elevated temperatures. Preferably mechanical surface disruption is undertaken substantially perpendicularly onto the upper surface of the photo-curable material by indentation of a rigid stamp or by injection of air delivered under continuous pressure.

Preferably the disruption of areas between the annealed areas takes place whilst the photo-curable material is cooling (i.e., changing from a semi-solid state to a solid state). The annealed areas support the upper ends or boundaries of arbitrarily sloped substructures, regions or side walls.

Preferably the greater the speed at which the material undergoes mechanical surface disruption while the material is changing (i.e. cooling) from a semi-solid to a solid state, the smaller the angle of the side wall of the microsctructure with respect to the vertical that is produced.

Photo-lithographic patterning of the deformed surfaces resulting from the mechanical surface disruption step can be undertaken by proximity printing using a glass plate photomask, or by contact printing using specially prepared polymeric masks. A glass-plate photomask in one example is in the form of a square glass plate with a patterned emulsion of metal film on one side. It is difficult to pattern the deformed areas by proximity printing without running into mask-alignment difficulties due to the presence of many irregular gaps between the glass plate photomask and the deformed areas. Contact printing using polymeric masks can be employed as a preferred alternative to proximity printing. Prior to mechanical surface disruption, polymeric masks can be deposited and photo-lithographically pre-patterned with required geometric features onto the regions which are to be deformed by mechanical surface disruption. A polymeric mask is perferably a deformable and poorly UV-transparent thin film which can be photosensitive or non-photosensitive and which is applied to the upper surface of the photocurable material. While a photosensitive thin film can be directly patterned using standard photoresist processing procedures, the patterning of a non-photosensitive thin film requires the use of a photoresist and more processing steps. The patterning of non-photosensitive thin film normally begins with spin-coating a non-photosensitive layer onto the top of the photocurable material forming the microstructures. A sacrificial photoresist layer is then spin-coated on top of the said non-photosensitive thin film. The sacrificial photoresist coating is then patterned using standard photoresist processing procedures. The patterns on the sacrificial photoresist coating are then transferred using wet etching or plasma etching through the non-photosensitive thin film.

The polymeric mask members are movable from a substantially planar configuration, in which they are initially applied to the upper surface of the photo-curable material, to a sloped or non-planar configuration following mechanical surface disruption. The polymeric mask member is used to define or help to define geometric features on one or more sloped or non-horizontal surfaces of the microstructure or one or more three-dimensional substructures within the side walls, such as the formation of one or more recesses, apertures or windows in the profiled side walls of the microstructure. The polymeric mask member is located on one or more areas of the photocurable material (on an upper surface thereof) which will eventually form the arbitrarily sloped side walls or substructures of the structure prior to disruption thereof.

Preferably the polymeric mask member is formed from a substantially flexible material.

Preferably the polymeric mask is made with a polymeric material and is typically provided in a photolithographically pre-patterned layer on the surface of the photo-curable material forming the microstructure. The polymeric mask member can include post-baked SU-8 patterns having had a brief exposure to UV light of about 2 seconds, be photoresist with poor UV transparency, a polyamide, a photosensitive resin pre-mixed with poorly UV transparent ceramic powder and/or the like. Thus, by developing polymeric mask regions on the surface of the photocurable material forming the microstructure, geometric features to be fabricated on the sloped surfaces or regions can be defined.

The polymeric mask member can be capable of being elongated/expanded to any required length which accommodates the surface displacement during the course of mechanical surface disruption, typically has poor-ultra-violet transparency, typically has a similar expansion coefficient as the photocurable material forming the microstructures, typically behaves as a thermoplastic, and/or is preferably photocurable. It is important that the mask material does not intermix with the photocurable material forming the microstructure.

Preferably the pressure applied to the metal layers for mechanical surface disruption of the photo-curable material is in a direction substantially perpendicular to the upper surface of the photocurable material forming the final microstructure(s).

In one embodiment the photocurable material forming the microstructures is mechanically disrupted using mechanical stamp means. The profile of the side walls of the structure formed using this technique are typically convex.

In an alternative embodiment the photocurable material forming the microstructures is disrupted using air delivered under pressure to the upper surface of the photocurable material forming the microstructure, such as by air injection. The air is typically hot air (i.e. above room temperature) and typically results in one or more side walls of the microstructure being substantially concave in shape.

In this disclosure, a sloped or profiled substructure, region or side wall is defined as surface between an upper region or boundary and a lower region or boundary where the angle with respect to the vertical changes therealong. The sloped or profiled substructures formed using the process of the present invention which can be concave, convex, arbitrarily shaped, planar and/or the like. The process can be used to produce a plurality of substructures at any time and said substructures can be interconnected by planar or non-planar regions or be separate to form one or more three-dimensional microstructures. The thicknesses of the side walls can also be varied as required.

The present invention therefore has the advantage over prior art micro-machining techniques in that the provision of polymeric masks allow a side wall of the microstructures to be photolithographically patterned without overly running into optical problems which cause mask alignment difficulties.

The present invention is a mask based micromachining technology which favours batch mode processing of the microstructures and there is no requirement for any expensive equipment to be employed.

Preferably it is the profile between the upper boundary (uppermost edge or surface) of the microstructure and the lower boundary (lowermost edge or surface) of the microstructure which is sloped.

Preferably annealing of the one or more regions of the photocurable material is undertaken using conventional photolithography.

Photopolymerisation of the end microstructure can also be undertaken using conventional photolithography.

Preferably, if the mechanical surface disruption is undertaken using a solid stamp, the size of a lower boundary of the microstructure (either within the structure or between adjacent structures) is defined at least in part by the size of the metal layers applied to the upper surface of the photo-curable material.

The size of the upper boundary of the microstructure is dependent on the size of the annealed or partially annealed areas of the photo-curable material forming the microstructure. The annealed or partially annealed areas are photolithographically formed using a photo-mask. The size of the lower boundary is defined by the degree of mechanical surface disruption of the photo-curable material forming the microstructure.

The upper and/or lower boundaries can be annular, include a point, a line or any other required shape.

Preferably the photocurable material forming the microstructure is a solvent based, negative photocurable material, and typically exhibits thermoplastic and viscoelastic properties when substantially void of solvent, such as SU-8.

The present invention can be used to enhance the ease with which micro-electromechanical structures ranging from a few microns square to a few centimetres square can be manufactured. The technology of the present invention can be used in micro-scale to form nozzle or diffuser elements in micro-fluidic devices, aerodynamic structures for rotary applications, three-dimensional packages for radio-frequency micro-electromechanical systems, three-dimensional micro coolers for power electronics, horns or reflectors for submillimeter wave transmitters or receivers and/or the like. The technology can also be used in millimetre or centimetre scale to form mold-less three-dimensional components, such as millimetre-wave antennas.

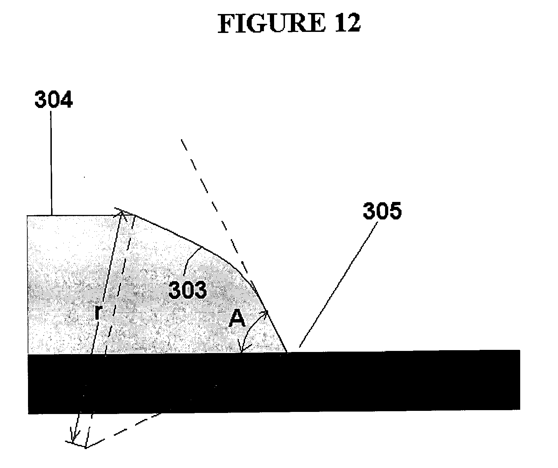

In this disclosure, a microstructure is considered as an interconnection of one or more arbitrarily sloped substructures, regions or side walls. A arbitrarily sloped substructure, region or side wall is defined as surface between an upper region or boundary and a lower region or boundary where any angle with respect to the vertical changes therealong. The three-dimensional microstructures formed using the process of the present invention can be concave, convex, arbitrarily shaped, planar and/or the like. The surface of the substructures, regions, or sidewalls can be opened with windows, holes or other required geometric features. The thicknesses of the substructures, regions, or side walls can also be varied as required. Illustration of a convex substructure within a microstructure is given in figure 12, wherein 303 refers to the convex side wall, 304 refers to the upper region or boundary and 305 refers to the lower region or boundary.

Embodiments of the present invention will now be described with reference to the accompanying figures, wherein:

Figure 1 is a cross sectional view of the apparatus used in the micro-machining process according to an embodiment of the present invention showing the formation of a reservoir of a photocurable material;

Figure 2 illustrates the apparatus following dehydration of the photocurable material until it becomes substantially void of solvent with a tensile and non-adhesive skin accumulated on the upper surface;

Figure 3 illustrates the formation of metallic mask on an upper surface of the photocurable material where the photocurable material is unwanted;

Figures 4a illustrates the formation of partially annealed areas adjacent the upper surface of the photocurable material using a photomask and UV light;

Figure 4b illustrates the formation of partially annealed boundaries as a means of providing discontinuity in surface tension;

Figure 5 illustrates the formation of a polymeric mask on an upper surface of the photocurable material to allow photolithographic patterning of side walls of the microstructure;

Figure 6 illustrates a solid stamp used for mechanical disruption of the photocurable material in one embodiment of the present invention which is fabricated to map the valleys or grooves of the microstructure;

Figures 7a-7b illustrate the process steps involved in mechanical disruption using the solid stamp or nail bed punching in figure 6;

Figures 8a-8b illustrate the final selective photo-curing steps involved in polymerising the microstructures;

Figures 9a and 9b illustrate wafer arrangements for formation of a microstructure in one embodiment having inwardly tapering side walls;

Figures 9c-9d illustrate the formation of a microstructure in one embodiment in the form of a conical island and lateral flow of the semi-molten photocurable material following mechanical surface disruption respectively;

Figure 10a is a plot showing 1) different speeds of mechanical surface disruption against time and 2) temperature of the photocurable material against time;

Figure 10b illustrates the cross sectional gamma shaped groove profiles of the microstructures formed corresponding to the different speeds of mechanical surface disruption shown in figure 10a;

Figures 11a illustrates a) a plot showing surface disruption against time for the formation of straight and sloped sidewalls and b) temperature of the photocurable material against time. This plot illustrates the speed control of surface disruption required for formation of non-curved side walls or substructures, regions or side walls;

Figure 11b illustrates a cross sectional profile of a microstructure with two pre-cured substantially V-shaped grooves;

Figure 12 illustrates a three-dimensional substructure, region or side wall within a microstructure;

Figure 13a illustrates a) a deformed surface caused by a low-speed mechanical surface disruption stamping process;

Figure 13b illustrates a deformed surface caused by a high-speed mechanical surface disruption stamping process;

Figure 14 illustrates indentation of a rigid solid stamp with sizes *2a* and 2b onto a region enclosed by a rectangular upper boundary having sizes **2A and 2B.**

Figure 15 illustrates mechanical surface disruption using air delivered under pressure onto a region enclosed by boundary with sizes *2A* and *2B* (i.e. by injection of air).

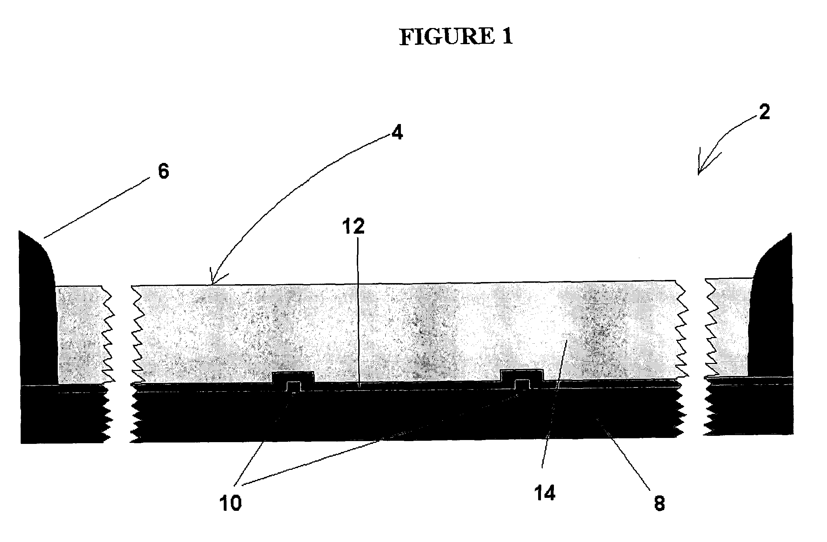

Referring to figure 1, there is illustrated apparatus 2 for use in a micro-machining process for the formation of micro-structures having one or more arbitrarily sloped side walls according to an embodiment of the present invention.

The apparatus includes a reservoir 4 formed by applying a non-adhesive plastic, such as FUN TAK™, to provide side walls 6 on a base member in the form of a wafer 8. Integrated circuits (ICs) 10 are provided on an upper surface 12 of wafer 8 to illustrate that the process of the present invention can be employed as a post-processing step for IC manufacture. The ICs are not essential for the process of the present invention.

A photo curable material 14 is located in reservoir 4, which in this example is SU-8 (from Microchem™), to a depth substantially equal to the height of the micro-structures to be formed. The depth is typically within the range of a few microns to 3mm.

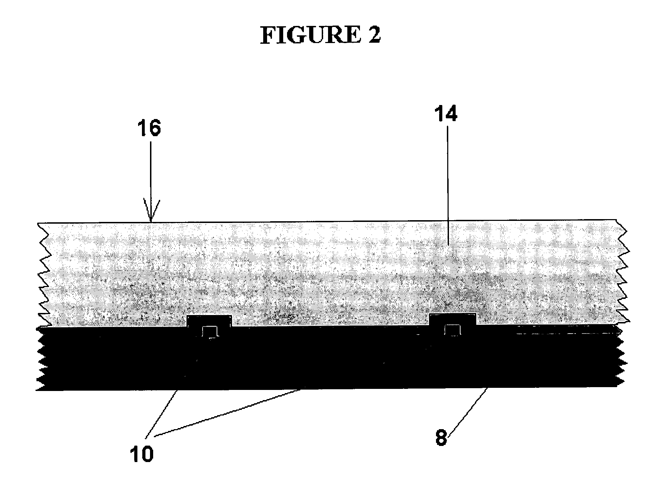

The photocurable material 14 is then dehydrated until it becomes substantially void of solvent with a tensile and non-adhesive skin on an upper surface 16 thereof, as shown in figure 2. The photocurable material below the upper surface 16 is in a semi-solid state following dehydration.

Dehydration of material 14 is achieved by heating the photocurable material to a suitable elevated temperature, such as 90°C, in an oxygen rich environment for a prolonged period of time, such as =3 hours, typically in a convective oven. The presence of oxygen in the ambient air reduces the surface adhesion, or equivalently, increases the surface tension of material 14 in reservoir 4.

Following dehydration, the reservoir of material is allowed to cool at room temperature until the photocurable material 14 becomes solidified.

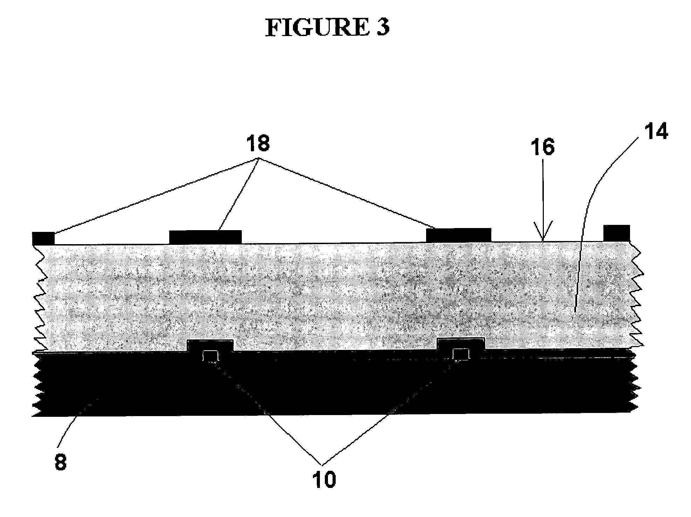

A plurality of metal layers 18 are applied to upper surface 16 of material 14, as shown in figure 3, on the areas of the photocurable material where material is not required in the end micro-structure being formed. The thickness of the metal layers 18 is typically between 1-2 microns. These metal layers typically define, at least in part, the lower boundaries of the microstructures.

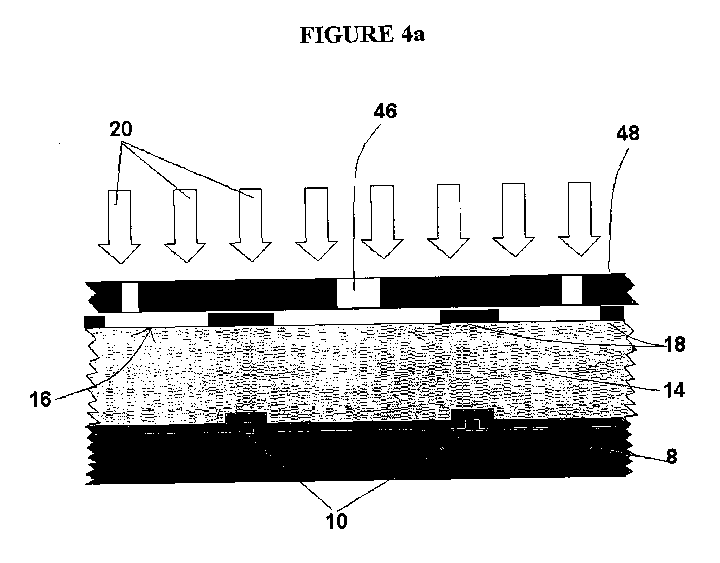

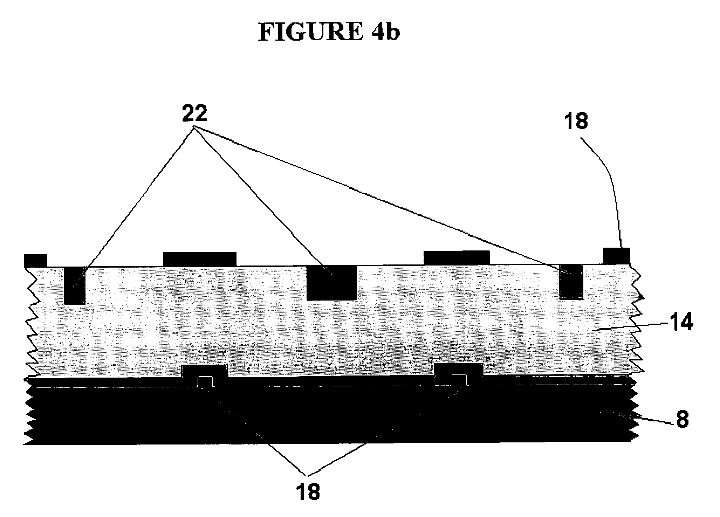

The upper boundaries of the microstructures are then defined, as shown in figures 4a and 4b, by polymerisation or partial polymerisation using conventional photolithography.

The upper boundaries of the microstructures are polymerised for the purposes of:

Limiting the height variation of the upper boundaries of the side walls of adjacent microstructures.
Generating surface discontinuity so that surface bending due to mechanical disruption of material 14 can be localised to the lower boundaries.

Selective polymerisation of the microstructure to form annealed areas is undertaken by selectively exposing certain regions of the photocurable material to UV light 20 using a photomask 48. A plurality of apertures 46 are provided in photomask 48 to allow exposure of certain regions of the photocurable material which are to define the upper boundaries of the arbitrarily sloped substructures, regions or sidewalls. This is known as photolithography.

Exposure of the photocurable material to UV light 20 causes polymerisation of the photocurable material in these exposed regions, thereby hardening the photocurable material in said regions and causing a change in the surface tension. This results in the exposed regions being resistant to the mechanical disruption of the photocurable material described later.

UV light 20 is directed onto upper surface 16 of material 14 for a pre-determined period of time. This pre-determined period of time of UV exposure is typically one eighth of the duration required to optically cure the entire reservoir of material 14. However, some regions of material 14 may require a longer exposure time to UV. The time required to photolithographically expose an area of material 14 which is to form the centre of a pyramidal island is closer to the duration required to optically cure the entire reservoir of material 14.

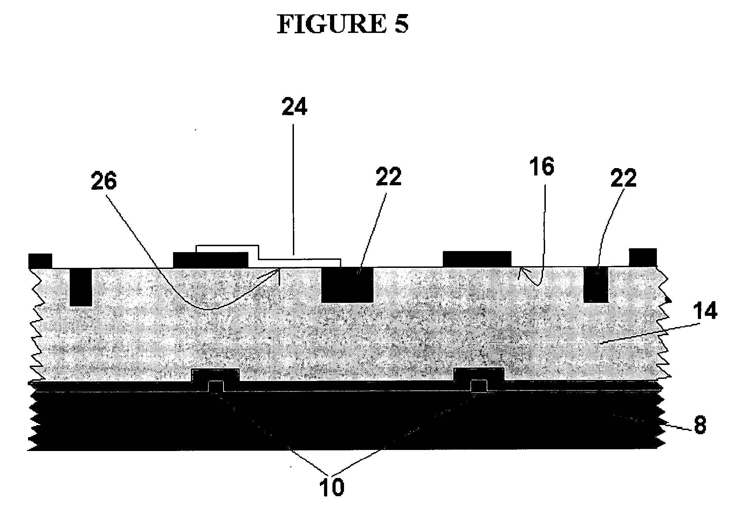

Once partially annealed areas 22 have been defined adjacent upper surface 16 of material 14, as shown in figure 4b, a flexible or polymeric mask member 24 is applied to upper surface 26 so as to selectively cover those regions of the microstructure which will form the arbitrarily sloped side walls in the end product, as shown in figure 5. Thus, the polymeric mask member 24 is applied to the upper surface 26 of material 14 where photocurable material is to be removed or is not required in the end structure.

It is important that the polymeric mask can be elongated or expanded mechanically, that it exhibits thermoplastic behavioural properties, has poor UV transparency, can be photolithographically patterned and does not intermix with material 14.

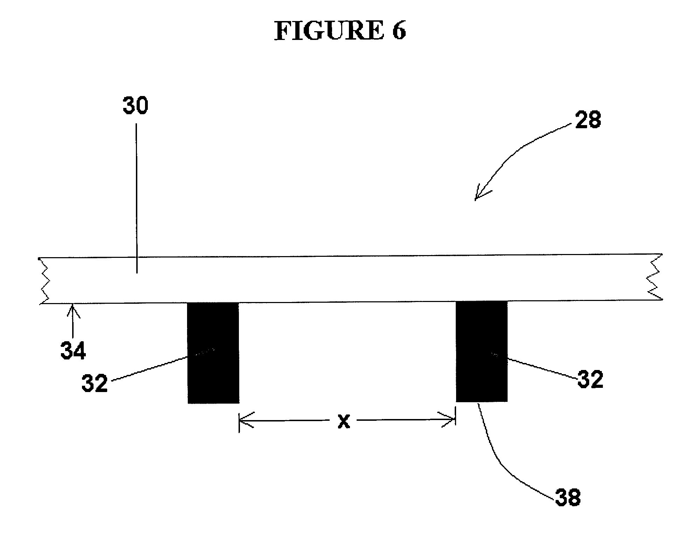

In order to mechanically disrupt upper surface 16 of material 14, pressure is applied thereto using a solid stamp 28, as shown in figure 6, in a direction substantially perpendicular to upper surface 16 (i.e. in a downwardly direction). Solid stamp 28 includes a glass plate 30 with rod members 32 protruding from a lower surface 34 thereof. Rod members 32 are formed from polymeric blocks made from photo-curable plastic. The distance 'x' between rod members 32 corresponds to the distant between recesses of the microstructures being formed. The number of rod members used on the solid stamp corresponds to the number of recesses required and the number of microstructures being formed.

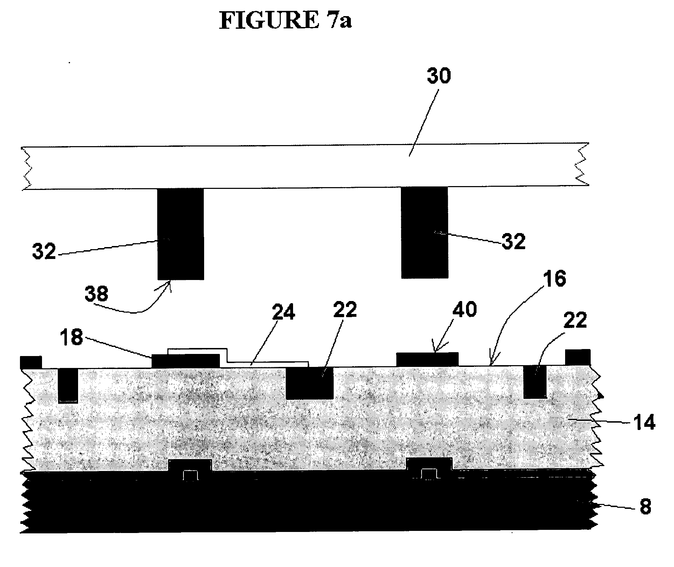

The reservoir of material 14 is reheated so that material 14 becomes semi-molten again. Reservoir 4 is then cooled down, either at room temperature or using temperature control means and, during this cooling, the solid stamp 28 is moved in a downwardly direction (as shown by arrows 36), with ends 38 of rod members 32 contacting the upper surface 40 of metal layers 18, thereby applying pressure to said surface 16 and causing mechanical disruption of material 14. The solid stamp is moved using a nail bed punching method in this example, as shown in figures 7a-7b.

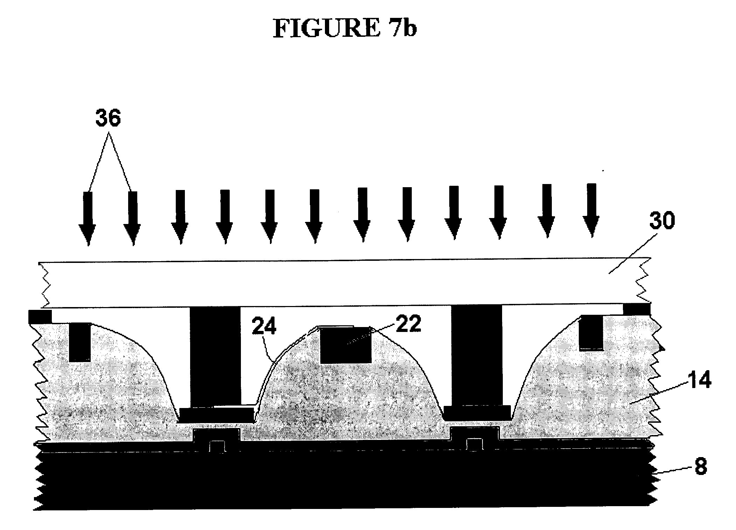

The areas of upper surface 16, between partially annealed areas 22, disrupt and form the side walls 42 of the microstructures 44, as shown in figure 7b.

The formation of the side walls in a required profile is described in more detail below. If the side walls are overly steep or not of the required shape as a result of the solid stamp being moved excessively fast, the profile of the same can be further refined by progressively warming the reservoir of material 14 using the heat source.

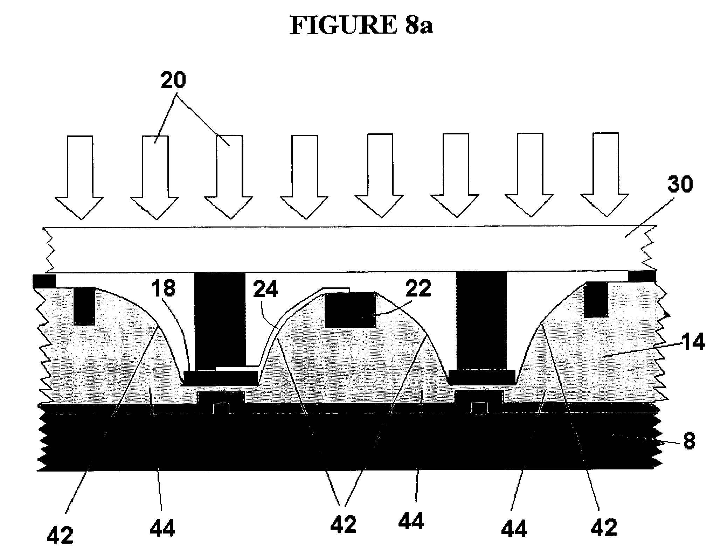

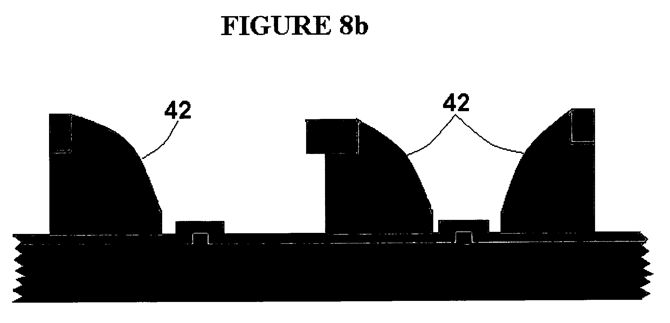

Once the required profile of the side walls is achieved, the photocurable material is photolithographically cured (Photo-polymerised) by exposing material 14 to UV light 20 again, as shown in figure 8a. The metal layers 18 and polymeric flexible mask 24 are removed, thus resulting in the formation of gamma shaped side walls 42, as shown in figure 8b.

The length of time for which the photocurable material is photo-cured for (i.e. photo-polymerised) by exposure to UV light 20 in the final step determines the thickness of the side walls of the microstructure 44. Typically, the longer the photo-curing time for which the final microstructure is photo-cured, the thicker the side walls of the final microstructure that are produced.

The degree of polymerisation of the upper boundaries to form the partially annealed regions 22 (as a result of exposure to UV light) can be varied to alter the shape of the resulting microstructures formed. The surface area of the annealed regions can be changed depending on the size of the apertures 46 provided in the photomask 48 being used. The profile of the side walls of the microstructure is also affected by the degree of polymerisation of the upper boundaries. This is because non-polymerised material (i.e. the regions of semi molten material between the annealed regions) tend to displace laterally or pile up during the course of mechanical surface disruption. Thus, the factors influencing the side walls are:

    a) whether the upper boundaries are sufficiently fixed in position; and
    b) whether or not there exists sufficient space underneath the partially annealed regions or boundaries for the semi-molten non-polymerised photocurable material to displace horizontally.

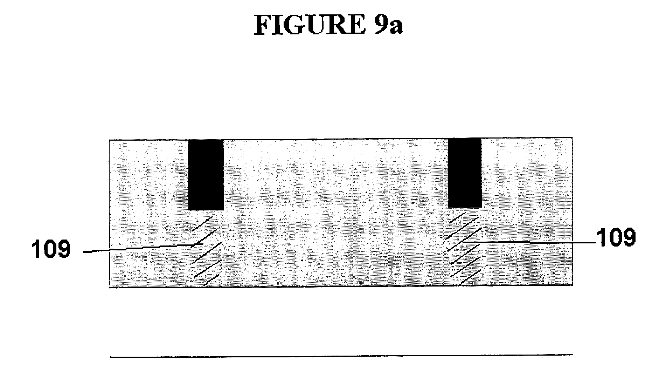

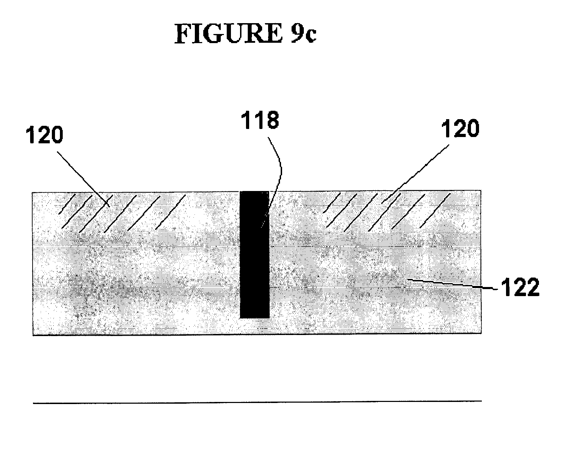

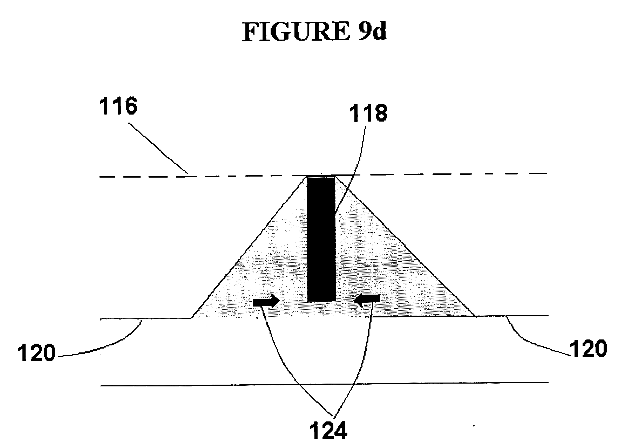

For example, formation of a microstructure 102 having a groove 104 with inwardly tapering side walls 106 in substrate 108 is illustrated in figures 9a-9b. The edges of the groove 104 are defined by upper boundaries 110 in the form of annealed regions. The base 112 of the structure 102 is formed as a result of mechanical disruption and the size thereof is reflective of the size of the metal layer that has been applied thereon during disruption. The clearance area 109 (shown by cross hatching) of material 108 underneath boundaries 110 allows a certain amount of semi-molten material to be displaced during the course of mechanical disruption, as shown by arrows 114. If, however, the clearance area under boundaries 110 is reduced due to deeper boundaries being produced, insufficient material 108 is displaced, thereby preventing the formation of arbitrarily sloped side walls 106.

A further example is illustrated in figures 9c-9d in which the formation of a microstructure 116 is provided in the form of a conical island or feature. In this case the upper boundary 118 is the centre of the feature and is hardened by photolithographic polymerisation in the manner described above. The area 120 surrounding the upper boundary 118 is mechanically disrupted. The directions in which the photocurable material 122 is displaced (shown by arrows 124) during the course of mechanical surface disruption almost cancel each other out underneath the upper boundary. If the upper boundary is not sufficiently polymerised, the surface disruption resulting in displacement of material 122 would lower the height of upper boundary 118.

The speed of mechanical surface disruption of the photocurable material and/or the rate at which the photocurable material is allowed to cool has direct impact on the cross sectional profile of the resulting microstructure. These parameters are used to control the profile or the slope of the sidewalls in the resulting microstructures.

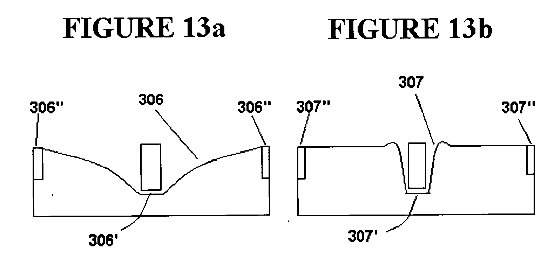

The difference between different speeds of mechanical surface disruption is graphically illustrated in Figure 13. The photocurable material in Figure 13.a experiences a mechanical surface disruption at relatively low speed as compared to that in figure 13.b. Referring to figure 13.a, the energy of the slow moving indentor (i.e. the solid stamp) is absorbed through either plastic or viscoelastic deformation in the vincity of the region of contact, 306'. With increasing contact time, a portion of the contact energy is also absorbed through global deformation of the surface, thus resulting in a much larger deformation of stretching, 306. The upper boundary 306" has an approximately zero second derivative of the bending moment, thus preventing the spread of the surface bending 306 beyond the region enclosed by the upper boundary, 306". However, as illustrated in Figure 13.b, when the surface of the photocurable material is mechanically disrupted at a higher speed, the deformation pattern, 307, become more localized to the region of contact 307'. The overall deformation pattern of Figure 13.b. is almost independent of the overall dimension of the photocurable material specimen. The degree of deformation varied according to the energy absorbed, which is a function of the speed of mechanical surface disruption.

When the reservoir of the photocurable material is cooling down, the viscosity and the plasticity of the photocurable material increases progressively until the photocurable material becomes completely solid. Thus, with increasing time into the cooling process, the resistance force of the photocurable material acting in an opposite direction to the mechanical disruption forces applied by the stamping process increases.

The mechanism of mechanical surface disruption at any speed can be modelled as an impact between a non-ballistic impactor and the photocurable material. The said impactor can be either air delivered under pressure or a rigid solid stamp as mentioned above. While in semi-molten state, the photocurable material deposited on a rigid substrate can be considered as a viscoelastic material because of its time-dependent stress-strain relations. The viscoelastic properties are characterised by creep or relaxation functions, thus taking into consideration the time-dependent behaviour of the photocurable material. In general, the surface displacement $u_z$ due to the force applied to a region enclosed by the upper boundary can be computed in rectangular coordinates by:

$$D\nabla^4 u_z(x,y,t) + c\frac{\partial u_z(x,y,t)}{\partial t} + m\frac{\partial^2 u_z(x,y,t)}{\partial t^2} = F(x,y,t) \qquad (1a)$$

wherein
$u_z(x,y,t)$ is the vertical displacement at *(x,y)* at time t as a result of mechanical surface disruption; D is the flexural rigidity given as:

$$D = \frac{E(t)h^3}{12(1-v(t)^2)} \qquad (1b)$$

with *E(t)*, $v(t)$ and *h* being respectively the young's modulus at time *t,* Poisson's ratio at time *t* and the thickness of the photocurable material; *m* is the mass per unit area given as:

$$m = \rho h \qquad (1c)$$

with $^\rho$ and $^h$ being the density and the thickness of the photocurable material, respectively; and c is the viscous damping coefficient which can be approximated as

$$c \approx \frac{\eta(T)}{h} \qquad (1d)$$

with $\eta(T)$ being the temperature-dependent viscosity.
*F(x,y,t)* of Equation (1) is the forcing function, which can be separated in the spatial function *Q(x,y),* characterizing the spatial distribution of the pressure, and the time domain function *P(t):*

$$F(x,y,t) = P(t)Q(x,y) \qquad (1e)$$

The laplacian operator of Equation (1) is, in rectangular coordinates:

$$\nabla^4 = \left\{ \frac{\partial^4}{\partial x^4} + 2\frac{\partial^4}{\partial x^2 \partial y^2} + \frac{\partial^4}{\partial y^4} \right\} \qquad (2a)$$

or, in polar coordinates:

$$\nabla^4 =$$

$$\left\{ \frac{1}{r^3}\frac{\partial}{\partial r} - \frac{2}{r^2}\frac{\partial^2}{\partial r^2} + \frac{4}{r^4}\frac{\partial^2}{\partial \theta^2} + \frac{2}{r}\frac{\partial^3}{\partial r^3} - \frac{2}{r^3}\frac{\partial^3}{\partial r \partial \theta^2} + \frac{2}{r^2}\frac{\partial^4}{\partial r^2 \partial \theta^2} + \frac{\partial^4}{\partial r^4} + \frac{1}{r^4}\frac{\partial^4}{\partial \theta^4} \right\}$$

$$(2b)$$

During the course of mechanical surface disruption, the photocurable material is assumed to be in a state of plane stress relative to the (x,y)-plane, i.e.

$$\sigma_{xz} = \sigma_{yz} = \sigma_{zz} = 0. \tag{3a}$$

The vertical displacement at the upper boundary is zero:

$$u_z = 0 \tag{3b}$$

and, for a fully annealed upper boundary, the second derivatives of the bending moment at the upper boundary is approximately zero:

$$-D\left(\frac{d^2}{dy^2} + \frac{d^2}{dy^2}\right)u_z(x,y,t) \approx 0 \tag{3c}$$

or in polar coordinates,

$$-D\left(\frac{d^2}{dr^2} + \frac{1}{r^2}\frac{d^2}{d\theta^2}\right)u_z(r,\theta,t) \approx 0 \tag{3d}$$

Equation (1) can be computed numerically using finite element analysis. While exact solution of Equation (1) is not often possible, closed form approximation is technically feasible for number of practical cases. Using the modal analysis, Equation (1) can be replaced by a set of infinite uncoupled ordinary differential equations. Using the expansion theorem, the solution of Equation (1) can be expressed in terms of a superposition of eigenfunctions $H_{i,k}(x,y)$ multiplying with the corresponding time-domain functions $R_{i,k}(t)$ so that, in rectangular coordinates,

$$u_z(x,y,t) = \sum_{i=1}^{\infty}\sum_{k=1}^{\infty} H_{ik}(x,y)R_{ik}(t) \tag{4}$$

Following some algebraic re-arrangements, the vertical displacement at any point *(x,y)* within the area enclosed by the upper boundary, *A,* can be expressed as:

$$u_z(x,y,t) = \sum_{i=1}^{\infty}\sum_{j=1}^{\infty} \frac{H_{ik}(x,y)}{m\omega_{ik}\sqrt{\xi_{ik}^2 - 1}} \frac{\iint_A H_{ik}(x,y)Q(x,y)dxdy}{\iint_A H_{ik}(x,y)^2 dxdy}$$

$$\int_0^t P(\tau)\left\{\exp\left[-\omega_{ik}(\xi_{ik} + \sqrt{\xi_{ik}^2 - 1})(t-\tau)\right] + \exp\left[-\omega_{ik}(\xi_{ik} - \sqrt{\xi_{ik}^2 - 1})(t-\tau)\right]\right\}d\tau \tag{5a}$$

wherein

$$\omega_{ik} = \sqrt{\frac{D}{m} \frac{\iint_A \left[H_{ik}(x,y)\nabla^4 H_{ik}(x,y)dxdy\right]}{\iint_A \left[H_{ik}(x,y)^2 dxdy\right]}} \qquad (5b)$$

and

$$\xi_{ik} = \frac{c}{2\sqrt{mD \frac{\iint_A \left[H_{ik}(x,y)\nabla^4 H_{ik}(x,y)dxdy\right]}{\iint_A \left[H_{ik}(x,y)^2 dxdy\right]}}} \qquad (5c)$$

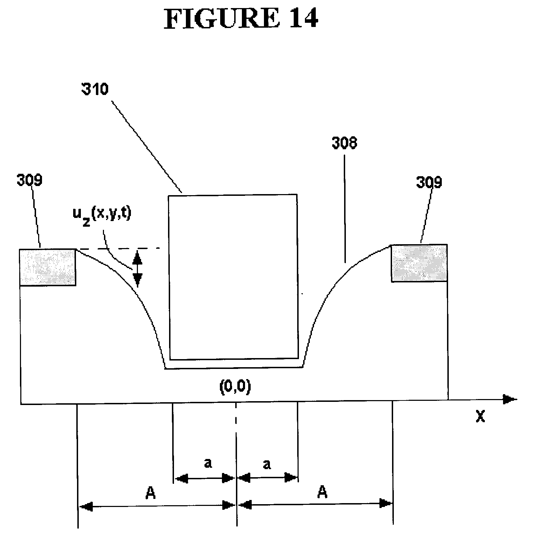

By way of an example, reference is made to Figure 14, wherein a flat-ended solid stamp 310 with sizes *2a* and *2b* is pressed onto the centre of the region enclosed by rectangular upper boundary 309 having sizes *2A* and 2B. The origin of the x-y plane is assumed to be in the centre of the rectangular boundary and in the centre of the stamp. Therefore, the coordinates of the four corners of the upper boundary are *(A,B), (A,-B), (-A,B)* and *(-A,-B),* whilst the coordinates of the four corners of the stamp are *(a,b), (a,-b), (-a,b)* and *(-a,-b).* The pressure distribution of stamp is assumed as:

$$F(x,y,t) = P(t)Q(x,y) = P(t)\int_{-b}^{b}\int_{-a}^{a} \frac{dxdy}{\sqrt{\left(1-\left(\frac{x}{a}\right)^2\right)\left(1-\left(\frac{y}{b}\right)^2\right)}} \qquad (6a)$$

For a annealed or partially annealed upper boundary, the eigenfunctions are:

$$H_{ik}(x,y) = \frac{1}{\sqrt{mAB}}\sin\left(\frac{i\pi}{2A}(x+A)\right)\sin\left(\frac{j\pi}{2B}(x+B)\right) \qquad (6b)$$

with *i,k =1,2 ...* ∞, so that:

$$\int_{-B}^{B}\int_{-A}^{A} H_{ik}(x,y)^2 \, dxdy = \frac{1}{\sqrt{mAB}}\sin\left(\frac{i\pi}{2A}(x+A)\right)\sin\left(\frac{j\pi}{2B}(x+B)\right) \qquad (6c)$$

$$\int_{-b}^{b}\int_{-a}^{a} Q(x,y)H_{ik}(x,y)dxdy = ab\pi^2 J_0\left(\frac{i\pi a}{2A}\right)J_0\left(\frac{k\pi b}{2B}\right)\sin\left(\frac{i\pi}{2}\right)\sin\left(\frac{k\pi}{2}\right) \qquad (6d)$$

$$\int\limits_{-b}^{b}\int\limits_{-a}^{a} H_{ik}(x,y)^2\,dx\,dy = \frac{1}{m^2 AB} \tag{6e}$$

By substituting Equation (6a-e) into Equation (5a), the vertical displacement at any surface point *(x,y)* within the upper boundary can be approximated in closed form as:

$$u_z(x,y,t) = \sum_{i=1}^{\infty}\sum_{j=1}^{\infty} \frac{\dfrac{1}{\sqrt{mAB}}\sin\left(\dfrac{i\pi}{2A}(x+A)\right)\sin\left(\dfrac{j\pi}{2B}(x+B)\right)}{m\omega_{ik}\sqrt{\xi_{ik}^{\,2}-1}}$$

$$\times \frac{ab\pi^2 J_0\left(\dfrac{i\pi a}{2A}\right)J_0\left(\dfrac{k\pi b}{2B}\right)\sin\left(\dfrac{i\pi}{2}\right)\sin\left(\dfrac{k\pi}{2}\right)}{m^2 AB}$$

$$\times \int\limits_{0}^{t} P(\tau)\left\{\exp\left[-\omega_{ik}(\xi_{ik}+\sqrt{\xi_{ik}^{\,2}-1})(t-\tau)\right]+\exp\left[-\omega_{ik}(\xi_{ik}-\sqrt{\xi_{ik}^{\,2}-1})(t-\tau)\right]\right\}d\tau \tag{6f}$$

wherein:

$$\omega_{ik} = \sqrt{\frac{D}{m}}\,\frac{\pi^2}{4}\left[\left(\frac{i}{A}\right)^2+\left(\frac{k}{B}\right)^2\right] \tag{6g}$$

and

$$\xi_{ik} = \frac{c}{\sqrt{mD}\,\dfrac{\pi^2}{4}\left[\left(\dfrac{i}{A}\right)^2+\left(\dfrac{k}{B}\right)^2\right]} \tag{6h}$$

The time domain expressions for the Young's modulus *E(t)* can be approximated using the rational of Cheng (2000, Ref [1]) as:

$$E(t) = E_1\left\{dirac(t) - \frac{E_1}{3\eta}\exp\left[-\frac{2E_1(1+v_2)+3E_2}{6\eta(T)(1+v_2)}t\right]\right\} \tag{7a}$$

The pressure at the origin of the *x-y* plane, *P(t),* can be approximated in terms of the stamping speed (i.e. the speed of mechanical surface disruption) using the rational of Cheng (2000, Ref [1]) as:

$$P(t)\Big| = \frac{2E_1}{\pi\left(v_1^2 - 1\right)}$$

$$\times \int_0^t \frac{\partial}{\partial \tau} u_z(x,y,\tau) \left\{ \begin{array}{c} \dfrac{E_1(v_1-1)(v_2+1)}{2[E_2(1+v_1)+E_1(1+v_2)]} \exp\left(\left(\dfrac{E_1}{(v_1+1)}+\dfrac{E_2}{(v_2+1)}\right)\dfrac{(\tau-t)}{2\eta(T)}\right) + \\[3mm] \dfrac{E_1(v_1+1)(v_2+1)}{54[3E_2(1-v_1)+E_1(1+v_2)]} \exp\left(\left(\dfrac{-3E_2}{(v_2+1)}+\dfrac{E_1}{(v_1+1)}\right)\dfrac{\tau-t}{6\eta(T)}\right) + \\[3mm] \dfrac{E_2\left(v_1^2-1\right)[2E_1(1+v_2)+E_2]}{2[3E_2(1-v_1)+E_1(1+v_2)][E_2(1+v_1)+E_1(1+v_2)]} \end{array} \right\} d\tau$$

$$(7b)$$

In Equations (7a-b) $v_1$ and $v_2$ are assumed to be constant at v, i.e. the Poisson's ratio of the photocurable material. $E1$ and $E2$ represent the young's moduli of the two string elements in a linear phenomenological model consisting of combination of mass, two springs and one dashpot. $E1$ and $E2$ can be experimentally characterized using the following equations:

$$E_1 = \frac{3P(0)}{8x(0)} \qquad (8a)$$

$$E_2 = E_1\left(\frac{P(\infty)}{P(0)-P(\infty)}\right) \qquad (8b)$$

The temperature-dependent viscosity $\eta(T)$ of the photocurable material can be experimentally characterized using the following approximation

$$\eta(T) = \frac{E_2 t}{3\ln\left(\dfrac{P(0)-P(\infty)}{P(t)-P(\infty)}\right)}\left(1-\frac{T}{T_c}\right)^n \qquad (8c)$$

wherein n is a constant dependent upon the physical nature of the photocurable material, typically in the neighbourhood of 1.4 for most photocurable materials, $T$ is the temperature of the photocurable material and $T_c$ is the reference temperature.

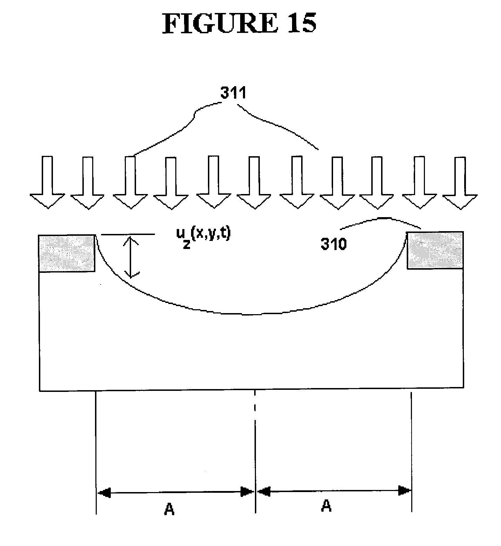

By way of example, reference is given to Figure 15 wherein a region enclosed by a rectangular upper boundary 310 with sides $2A$ and $2B$ is pressurized by air 311 delivered under a pressure $P(t)$. The origin of the x-y plane is assumed to be in the centre of the rectangular boundary, or in the centre of the stamp. The four corners of the upper boundary are $(A,B)$, $(A,-B)$, $(-A,B)$ and $(-A,-B)$. The pressure distribution due to the air delivered under pressure $P(t)$ is assumed to be uniformly distributed, i.e.

$$F(x,y,t) = P(t)Q(x,y) = P(t) \qquad (9a)$$

wherein $Q(x,y) = 1$.

By substituting Equation (9a) and Equation (6a-e) into Equation (5a), the vertical displacement at any surface point *(x,y)* within the upper boundary can be approximated in closed form as:

$$u_z(x,y,t) = \sum_{i=1}^{\infty}\sum_{j=1}^{\infty} \frac{\frac{1}{\sqrt{mAB}}\sin\left(\frac{i\pi}{2A}(x+A)\right)\sin\left(\frac{j\pi}{2B}(x+B)\right)}{m\omega_{ik}\sqrt{\xi_{ik}^{2}-1}}$$

$$\times \frac{1}{m^2 AB}$$

$$\times \int_0^t P(\tau)\left\{\exp\left[-\omega_{ik}(\xi_{ik}+\sqrt{\xi_{ik}^2-1})(t-\tau)\right]+\exp\left[-\omega_{ik}(\xi_{ik}-\sqrt{\xi_{ik}^2-1})(t-\tau)\right]\right\}d\tau$$

$$(9b)$$

wherein $\omega_{ik}$ and $\xi_{ik}$ can be obtained from Equation (6g) and (6h).

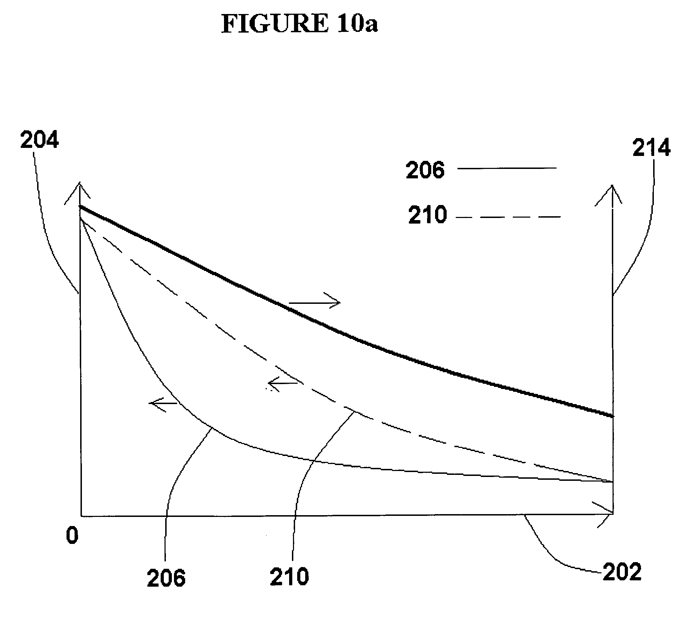

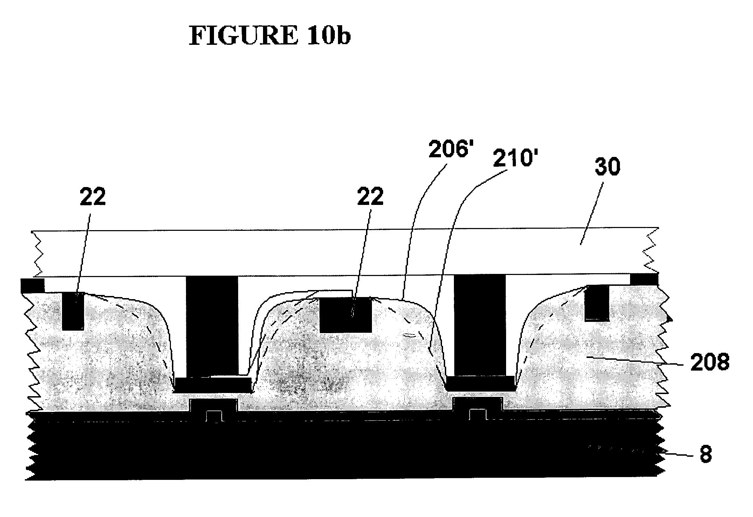

By way of example, reference is made to the plot shown in figure 10a, wherein the horizontal axis 202 represents time and the vertical axis 204 represents the vertical distance of the downward movement of the solid stamp during the mechanical surface disruption process. Line 206 represents mechanical surface disruption of the photocurable material 208 following a rapid stamping process 206' and line 210 represents mechanical disruption of material following a slower stamping process 210'. The resulting cross sectional profiles of the resulting microstructures are illustrated in figure 10b. The rapid stamping process 206' produces a steeper side wall than the slower stamping process 210'. Line 212 represents the change in temperature (shown on vertical axis 214) of the photocurable material with time.

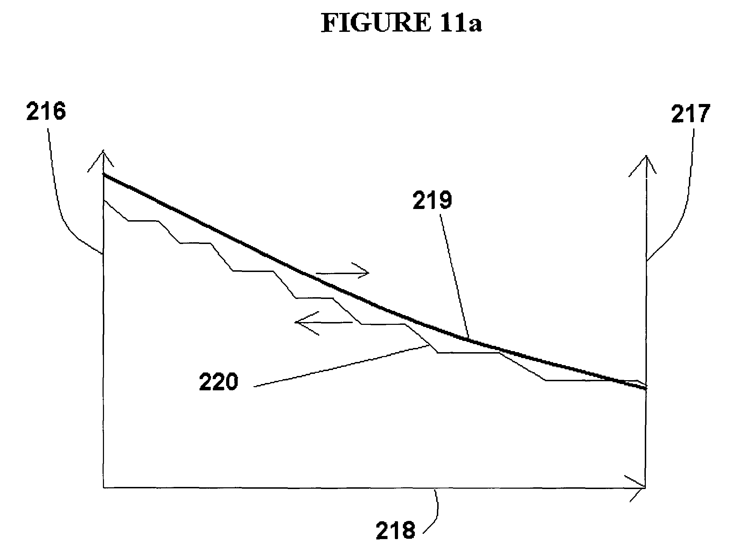

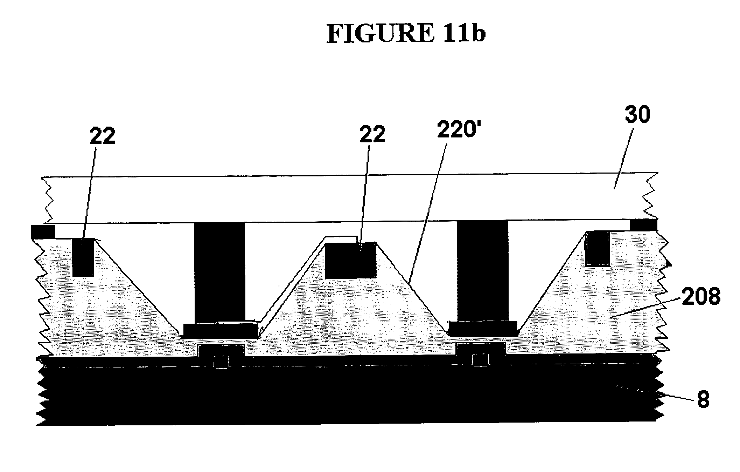

As another example, reference is made to the plot shown in figure 11a, wherein the horizontal axis 218 represents time and the vertical axis 216 represents the vertical distance of the downward movement of the solid stamp during the mechanical-surface-disruption process. Line 220 represents mechanical surface disruption of the photocurable material 208 following a stamping process 220'. The delays, as indicated by diagonals in line 220, are intended for allowing additional cooling for the photocurable material 208 during the mechanical surface disruption process. The resulting cross sectional profiles of the resulting microstructures are illustrated in figure 11b. By allowing more delays during the mechanical surface disruption process, the plasticity and the viscosity of material 208 significantly increases through cooling of the photocurable material 208. The interaction between the increase in viscosity of the photocurable material 208 and the progressive downward movement of the solid stamp results in a near V-shaped profiles 220' in the resulting microstructure.

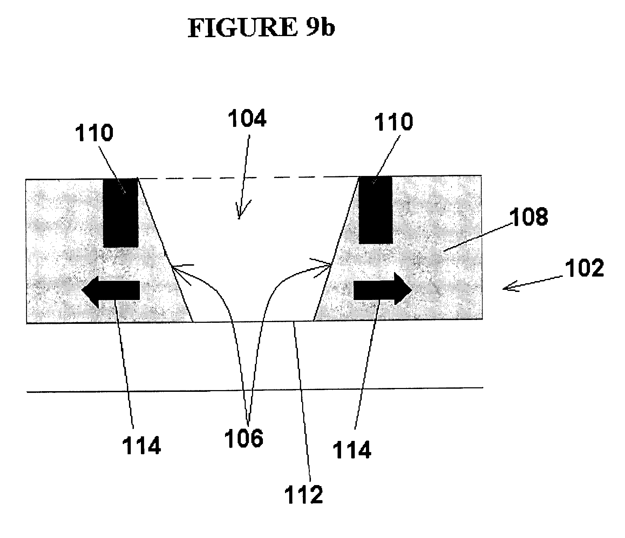

The photocurable material 4 is a solvent based, negative photocurable material which exhibits thermoplastic and viscoelastic properties when substantially void of solvent. Photocurable SU-8 (formulated as 20% of gamma butyrolactone, 80% of epoxy resin and triarylsulfonium salt) and photocurable bisphenol-B/allumina composite have been experimented in the present invention with success. In the case of the abovementioned SU-8, the depth of reservoir 4 is typically within the range of a few microns to 3 mm. The temperature for dehydration of reservoir 4, as referred in figure 2, is typically 90°C and the dehydration time is typically within three hours. The wavelength of the UV light required for exposure in annealing the upper boundaries or regions, as referred to in figure 4, and for the final photo-curing step, as referred to in figure 8, is typically in the neighbourhood of 340 nano meters. The time required for photo-curing reservoir 4 having a depth of 3 mm is typically 30 minutes. The time required to photolithographically expose an area of reservoir 4 which is to form an edge of a recess in the end microstructure, depicted in figure 9a, would be one eighth of 30 minutes, i.e. 3.75 minutes. The time required to photolithographically expose an area of reservoir 4 which is to form the center of a pyramidal island depicted in figure 9b is closer to 30 minutes.

Whilst certain preferred embodiments and specifications of the present invention have been disclosed in detail, it should be understood that various changes and modifications may be made therein without departure from the scope of the appended claims.

References

[1] Cheng, X. Xia, W. Yu, L. E. Scriven, W. W. Gerberich, "Flat-Punch Indentation of Viscoelastic Material", Journal of Polymer Science: Part B: Polymer Physics, Vol. 38, pp 10-22, 2000.

**Claims**

1. A method for mass-fabricating one or more three-dimensional microstructures having arbitrarily sloped and/or profiled side walls or substructures, including the steps of :

   a) locating photo-curable material in a suitable reservoir;
   b) dehydrating the photo-curable material by heating;
   c) providing one or more metal layers on one or more areas of the photo-curable material for defining the lower boundaries of the microstructures being fabricated and for defining areas where said material in the micro structure is not required;
   d) forming one or more annealed or partially annealed areas adjacent at least an upper surface of the photo-curable material for formation of upper boundaries of the microstructures being fabricated;
   e) forming one or more polymeric mask regions on the material for defining one or more geometric features onto one or more sloped surfaces of the microstructure;
   f) heating the photo-curable material from solid to semi-solid;
   g) mechanically disrupting the areas between or enclosed by the annealed or partially annealed areas by applying pressure to form a microstructure having arbitrarily sloped and/or profiled sidewalls and/or substructures whilst the photocurable material is cooling; and
   h) photopolymerising the regions of the photo-curable material required for forming the microstructure.

2. The method of claim 1 wherein
   the material forming the three-dimensional microstructures is a photocurable material having a substantially adhesionless surface and thermoplastic behaviours.

3. The method of claim 1
   **characterised in that** mechanical surface disruption is realized by mechanically deforming the flatness of one or more regions enclosed by or in the vicinity of boundaries annealed or partially annealed on the surface of the photocurable material forming the three-dimensional microstructures, whilst the photocurable material is cooling from a semi-solid to a solid state.

4. The method of claim 1
   **characterized in that** any or any combination of the surface area of the annealed or partially annealed areas, the temperature of the photo-curable material at which mechanical disruption takes place and/or the speed at which the photo-curable material is mechanically disrupted can be changed to change the side wall profile of the microstructure formed.

5. The method of claim 1
   **characterised in that** pre-polymerized convex side walls or substructures are fabricated by mechanically indenting the selected viscoelastic sub-regions enclosed by or in the vicinity of one or more annealed or partially annealed upper boundaries using imprinting stamp means.

6. The method of claim 5
   **characterized in that** the imprinting stamp means is made with a glass plate fabricated with polymeric flat-end rods having required geometric patterns aligned with the lower boundaries of the side walls or substructures.

7. The method of claim 1
   **characterised in that** pre-polymerized concave side walls or substructures are fabricated by applying air pressure onto the selected viscoelastic regions enclosed by the annealed or partially annealed upper boundaries.

8. The method of claim 1 further
   **characterised by** the use of polymeric masks to allow contact printing of geometric patterns onto sloped or non-horizonal surfaces or subregions within a three-dimensional microstructures.

9. The method of claim 8
   **characterised by** the use of standard photomasks to allow proximity printing of geometric patterns onto sloped or non-horizontal surfaces or subregions.

FIGURE 1

FIGURE 2

# FIGURE 3

EP 1 671 925 A1

FIGURE 4a

EP 1 671 925 A1

**FIGURE 4b**

FIGURE 5

FIGURE 6

## FIGURE 7a

## FIGURE 7b

# FIGURE 8a

EP 1 671 925 A1

# FIGURE 8b

EP 1 671 925 A1

FIGURE 9a

109

109

FIGURE 9b

108

102

110

110

104

114

112

106

114

# FIGURE 9c

FIGURE 9d

**FIGURE 10a**

**FIGURE 10b**

FIGURE 11a

FIGURE 11b

**FIGURE 12**

FIGURE 13a

FIGURE 13b

# FIGURE 14

EP 1 671 925 A1

310

308

309

309

$u_z(x,y,t)$

(0,0)

X

a

a

A

A

## FIGURE 15

EP 1 671 925 A1

**European Patent Office**

## EUROPEAN SEARCH REPORT

Application Number

EP 04 02 8817

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| D,A | LIU W Y ET AL: "Polymer micro-heat-pipe for InP/InGaAs technologies" 10TH IEEE INTERNATIONAL SYMPOSIUM ON ELECTRON DEVICES FOR MICROWAVE AND OPTOELECTRONIC APPLICATIONS. EDMO 2002 (CAT. NO.02TH8629) IEEE PISCATAWAY, NJ, USA, 2002, pages 143-148, XP010625943 ISBN: 0-7803-7530-0 * the whole document * | | B81C1/00 G03F7/00 B29C59/02 |
| A | DE 196 52 463 A1 (FRIEDRICH-SCHILLER-UNIVERSITAET JENA, 07743 JENA, DE) 18 June 1998 (1998-06-18) | | |
| A | FEIERTAG G ET AL: "SLOPED IRRADIATION TECHNIQUES IN DEEP X-RAY LITHOGRAPHY FOR 3-D SHAPING OF MICROSTRUCTURES" PROCEEDINGS OF THE SPIE, SPIE, BELLINGHAM, VA, US, vol. 3048, 1997, pages 136-145, XP008013116 ISSN: 0277-786X | | |
| A | US 2002/018964 A1 (JEROMINEK HUBERT) 14 February 2002 (2002-02-14) | | |

**TECHNICAL FIELDS SEARCHED (Int.Cl.7)**

G03F
B81C
B29C

The present search report has been drawn up for all claims

| Place of search | Date of completion of the search | Examiner |
|---|---|---|
| The Hague | 13 September 2005 | Haenisch, U |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
........................................................................................
& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 04 02 8817

This annex lists the patent family members relating to the patent documents cited in the above-mentioned European search report.
The members are as contained in the European Patent Office EDP file on
The European Patent Office is in no way liable for these particulars which are merely given for the purpose of information.

13-09-2005

| Patent document cited in search report | Publication date | Patent family member(s) | Publication date |
|---|---|---|---|
| DE 19652463 A1 | 18-06-1998 | NONE | |
| US 2002018964 A1 | 14-02-2002 | NONE | |

EPO FORM P0459

For more details about this annex : see Official Journal of the European Patent Office, No. 12/82